# EUROPEAN PATENT SPECIFICATION

(11) **EP 2 889 921 B1**
(45) Date of publication and mention of the grant of the patent: **02.08.2017**
(21) Application number: 14162260.5
(22) Date of filing: 28.03.2014
(51) Int. Cl.: H01L 31/075, H01L 31/0392, H01L 31/0376, H01L 31/0352, H01L 31/0304, H01L 31/18, H01L 31/20

(54) **Solar cell with flexible substrate of adjustable bandgap quantum well structure and preparation method therefor**
Solarzelle mit Quantentopfstruktur mit einstellbarer Bandlücke auf einem flexiblen Substrat und Herstellungsverfahren dafür
Cellule solaire à substrat flexible de structure à puits quantique à bande interdite réglable et son procédé de préparation

(30) Priority: 30.12.2013 CN 201310742938
(43) Date of publication of application: 01.07.2015
(73) Proprietor: Shenyang Institute of Engineering, Shenyang Liaoning 110136 (CN)
(72) Inventor: Zhang, Tieyan, Shenyang Liaoning 110136 (CN); Zhao, Yan, Shenyang Liaoning 110136 (CN); Zhang, Dong, Shenyang Liaoning 110136 (CN); Ju, Zhenhe, Shenyang Liaoning 110136 (CN); Zheng, Hong, Shenyang Liaoning 110136 (CN); Li, Yucai, Shenyang Liaoning 110136 (CN); Song, Shiwei, Shenyang Liaoning 110136 (CN); Wang, Jian, Shenyang Liaoning 110136 (CN); Bian, Jiming, Shenyang Liaoning 110136 (CN); Liu, Baodan, Shenyang Liaoning 110136 (CN)
(74) Representative: Office Kirkpatrick

(56) References cited:
- KE TAO ET AL: "Low-temperature preparation of flexible a-Si:H solar cells with hydrogenated nanocrystalline silicon p layer", VACUUM, PERGAMON PRESS, GB, vol. 86, no. 10, 16 January 2012 (2012-01-16), pages 1477-1481, XP028510340, ISSN: 0042-207X, DOI: 10.1016/J.VACUUM.2012.01.011 [retrieved on 2012-01-24]
- ASHRAFUL GHANI BHUIYAN ET AL: "InGaN Solar Cells: Present State of the Art and Important Challenges", IEEE JOURNAL OF PHOTOVOLTAICS, I E E E, US, vol. 2, no. 3, 18 June 2012 (2012-06-18), pages 276-293, XP011460274, ISSN: 2156-3381, DOI: 10.1109/JPHOTOV.2012.2193384
- BERNHARD N ET AL: "BANDGAP ENGINEERING OF AMORPHOUS SEMICONDUCTORS FOR SOLAR CELL APPLICATIONS", PROGRESS IN PHOTOVOLTAICS: RESEARCH AND APPLICATIONS, JOHN WILEY & SONS, LTD, vol. 3, no. 3, May 1995 (1995-05), pages 149-176, XP000537258, ISSN: 1062-7995
- YAN BAOJIE ET AL: "On the bandgap of hydrogenated nanocrystalline silicon intrinsic materials used in thin film silicon solar cells", SOLAR ENERGY MATERIALS AND SOLAR CELLS, vol. 111, 23 January 2013 (2013-01-23), pages 90-96, XP028981752, ISSN: 0927-0248, DOI: 10.1016/J.SOLMAT.2012.12.038

## Description

### Technical Field

The present invention belongs to the field of flexible solar cell manufacturing technology, in particular relates to a solar cell with a flexible substrate of an adjustable bandgap quantum well structure and a preparation method therefor.

### Background

A solar cell with a flexible substrate refers to a thin film solar cell which is made on a flexible material, i.e. polyimide (PI) or flexible stainless steel. With the advantages of portability, light weight, non-frangible property and unique operational performance, and the thin film solar cell has strong market competitiveness. The existing thin film solar cells already in commercial applications are mainly based on glass substrates of noncrystalline silicon films, and the preparation method is as follows: using silane (SiH₄) doped with borane (B₂H₆) and phosphine (PH₃) to prepare a thin film on a cheap glass substrate at low temperature, and forming a photovoltaic PIN single-junction or multi-junction thin film solar cell structure.

Currently, most of the thin film solar cells with relatively mature technology are made of silicon-based material, and the I layers in PIN are generally noncrystalline or microcrystalline silicon (Si) films. The noncrystalline or microcrystalline silicon (Si) is also called amorphous silicon. As can be seen from its microscopic structure, amorphous silicon has a short-range ordered but long-range disordered random network structure with the defect of containing a large number of dangling bonds and vacancies. However, since the bandgap of a noncrystalline or microcrystalline silicon (Si) film is about 1.7eV, the film is not very sensitive to the long waves of solar radiation spectrum, thus the photoelectric conversion efficiency of the film is relatively low. Besides, there is a significant effect of light-induced degradation, which makes the photoluminescence property of a solar cell less stable, thus making the thin film solar cell have a poor market competitiveness.

The document "Low-temperature preparation of flexible a-Si:H solar cells with hydrogenated nanocrystalline silicon p layer" from KE TAO ET AL of January 16, 2012 discloses different bandgap engineering approaches with respect to their application in thin film solar cells based on hydrogenated amorphous silicon (a-Si:H) and its allys with Ge or C.

The document InGaN Solar Cells: Present State of the Art and Important Challenges" from ASHRAFUL GHANI BHUIYAN ET AL of June 18, 2012 present sa review on the state of the art of InxGa1-xN-based solar cells.

### Summary

In consideration of the shortage of the prior art, the present invention provides a solar cell with a flexible substrate of an adjustable bandgap quantum well structure and a preparation method therefor. The present invention uses an InₓGa₁₋ₓN crystal film of which the bandgap can be adjusted to the most sensitive range of a solar cell as the intrinsic layer (I layer) of a flexible solar cell, and the quantum well structure of the crystal film increases the photoelectric conversion efficiency of the solar cell and improves the stability of the photoluminescence property of solar cell.

The solar cell with a flexible substrate of an adjustable bandgap quantum well structure of the present invention uses polyimide (PI) as a flexible substrate, an AlN insulating layer is above the substrate, an Al back electrode is above the AlN insulating layer, a Ga-doped ZnO (GZO) transparent conductive film used as a buffer layer is above the Al back electrode, an N-type hydrogenated nano-crystalline silicon (nc-Si:H) film is above the GZO transparent conductive film, an I layer InₓGa₁₋ₓN intrinsic film is above the N-type nc-Si:H film, a P-type nc-Si:H film is above the I layer InₓGa₁₋ₓN intrinsic film, another GZO transparent conductive film is above the P-type nc-Si:H film, and an Al metal electrode is above the GZO transparent conductive film. The specific structure is Al electrode/GZO/P-type nc-Si:H/I layer InxGa₁₋ₓN film/N-type nc-Si:H/GZO/Al back electrode/AlN insulating layer/PI flexible substrate, wherein the InₓGa₁₋ₓN film has an adjustable bandgap width and a quantum well structure.

The preparation method for the solar cell with a flexible substrate of an adjustable bandgap quantum well structure of the present invention comprises the steps of:
(1) After ultrasonic cleaning by ionized water for 5 min, drying up the PI substrate by N₂ and putting the PI substrate into a magnetron sputtering reaction chamber to prepare the AlN insulating layer by deposition at a vacuum of 9.0 × 10⁻⁴ Pa; the process parameters are as follows: the target material is aluminum, the reaction source is the gas mixture of Ar and N₂, the flow ratio of Ar:N₂ is (4 to 10):1, the flexible PI substrate is heated to 100 to 200°C, and the deposition time is 30 to 60 min.
(2) Preparing the Al metal back electrode by magnetron sputtering; the process parameters are as follows: the target material is aluminum, the reaction source is Ar, the flow rate of Ar is 10 to 20 sccm, the temperature of the substrate is 50 to 150°C, and the deposition time is 3 to 10 min. The structure at this time is Al back electrode/AIN insulating layer/PI flexible substrate.
(3) Preparing one GZO transparent conductive film by an Electron Cyclotron Resonance Plasma Enhanced Chemical Vapor Deposition (ECR-PEMOCVD) system; the process parameters are as follows: the PI flexible substrate with deposited AlN insulating layer and Al back electrode in the reaction chamber is heated to 200 to 400°C, Ar carried trimethyl gallium (TMGa), diethyl zinc (DEZn) and O₂ are introduced to the reaction chamber, the flow ratio of TMGa:DEZn:O₂ is 1:2:80, the microwave power is 650 W, the deposition pressure is 0.8 to 1.2 Pa, and the deposition time is 10 to 20 min. The structure at this time is GZO/Al back electrode/AIN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 5 to 8 sccm, the flow rate of H₂ diluted PH₃ is 0.5 to 5 sccm, the flow rate of H₂ is 25 to 40 sccm, the deposition temperature is 250 to 350°C, the microwave power is 650 W, the deposition pressure is 0.8 to 1.2 Pa, and the deposition time is 30 to 80 min. The structure at this time is N-type nc-Si:H/GZO/Al back electrode/AIN insulating layer/PI flexible substrate.
(5) Preparing the InₓGa₁₋ₓN adjustable bandgap quantum well intrinsic crystal film by the ECR-PEMOCVD system and introducing H₂ diluted TMGa and trimethyl indium (TMIn) to the reaction chamber; the process parameters are as follows: the flow ratio of TMGa:TMIn is 2:1, the flow rate of N₂ is 80 to 120 sccm, the deposition temperature is 200 to 300°C, the microwave power is 650 W, the deposition pressure is 0.9 to 1.4 Pa, and the deposition time is 40 to 60 min. The structure at this time is I layer InₓGa₁₋ₓN intrinsic film/N-type nc-Si:H/GZO/Al back electrode/AIN insulating layer/PI flexible substrate.
(6) Preparing the P-type nc-Si:H film by the ECR-PEMOCVD system and introducing Ar diluted SiH₄ and H₂ diluted B₂H₆ to the reaction chamber; the process parameters are as follows: the flow rate of Ar diluted SiH₄ is 5 to 8 sccm, the flow rate of H₂ diluted B₂H₆ is 0.3 to 8 sccm, the flow rate of H₂ is 25 sccm, the deposition temperature is 250 to 350°C, the microwave power is 650 W, the deposition pressure is 0.8 to 1.2 Pa, and the deposition time is 30 to 80 min. The structure at this time is P-type nc-Si:H/I layer InₓGa₁₋ₓN intrinsic film/N-type nc-Si:H/GZO/Al back electrode/AIN insulating layer/PI flexible substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the deposition temperature is 200 to 400°C, the microwave power is 650 W, the deposition pressure is 0.8 to 1.2 Pa, and the deposition time is 10 to 20 min. The structure at this time is GZO/P-type nc-Si:H/l layer InₓGa₁₋ₓN intrinsic film/N-type nc-Si:H/GZO/Al back electrode/AlN insulating layer/PI flexible substrate.
(8) Preparing the Al metal electrode by the magnetron sputtering reaction chamber; the process parameters are as follows: the reaction source is Ar, the target material is aluminum, the flow of Ar is 10 to 20 sccm, the temperature of the substrate is 50 to 150°C, and the deposition time is 3 to 10 min. The structure finally obtained is Al electrode/GZO/P-type nc-Si:H/l layer InₓGa₁₋ₓN intrinsic film/N-type nc-Si:H/GZO/Al back electrode/AlN insulating layer/PI flexible substrate.

The target material of aluminum used during magnetron sputtering has a purity of 99.99%.

The value of x in the InₓGa₁₋ₓN quantum well intrinsic crystal film is between 0 and 1. Compared with prior art, the present invention has the following characteristics and advantages:
The flexible substrate used in the flexible solar cell with a structure of Al electrode/GZO/P-type nc-Si:H/I layer InₓGa₁₋ₓN film/N-type nc-Si:H/GZO/Al back electrode/AlN insulating layer/PI flexible substrate of the present invention is PI, the most distinct characteristics of the flexible solar cell are light in weight, easy to carry about and not easy to crush, and the gravimetric specific power and volumetric specific power of the flexible solar cell are several orders of magnitude higher than those of other kinds of cells. The present invention has good flexibility, thus can be crimped, cut out and pasted freely. In the present invention, the material and structure of the I layer are changed, and the InₓGa₁₋ₓN adjustable bandgap quantum well intrinsic crystal film is introduced and used as the I layer; since the lnₓGa₁₋ₓN material has good stability, corrosion resistance, tunneling potential barrier and low optical loss coefficient, the conversion efficiency of the cell is increased. In the present invention, the GZO transparent conductive film is added between the Al back electrode and the N-type nc-Si:H film, wherein the GZO transparent conductive film is used as both a buffer layer and a transparent conducting electrode, which increases the transmittance of the thin film solar cell and improves the corrosion resistance of the transparent electrode, thus the photoelectric conversion efficiency of the thin film solar cell is greatly increased. In the present invention, AlN is used as the insulating layer, the lattice mismatch ratio of AlN is small, and the Al back electrode with uniform quality can be prepared.

In conclusion, the solar cell with a flexible substrate of an adjustable bandgap quantum well structure of the present invention has excellent flexibility and light weight, is easy to carry, and has industrial potential and market space. Besides, the preparation process of the solar cell of the present invention is simple, which enables the solar cell to be produced in large scale.

### Description of Figures

Figure 1 is the structure diagram of the solar cell with a flexible substrate of an adjustable bandgap quantum well structure of the present invention.
Figure 2 is the flow chart for preparing the solar cell with a flexible substrate of an adjustable bandgap quantum well structure of the present invention.
Figure 3 is the Atomic Force Microscopy (AFM) image of the InₓGa₁₋ₓN quantum well intrinsic crystal film in Embodiment 1 of the present invention.
Figure 4 is the X-ray Photoelectron Spectroscopy (XPS) analysis chart of the P-type nc-Si:H film in Embodiment 1 of the present invention.
Figure 5 is the Raman line of the P-type nc-Si:H film in Embodiment 1 of the present invention.
Figure 6 is the AFM image of the P-type nc-Si:H film in Embodiment 1 of the present invention.

### Detailed Description

The embodiments of the present invention are described in detail as follows, but the scope of the present invention is not limited to the following embodiments:
In the present invention, a RENISHAW in Via Raman Microscope spectrometer is used to test the Raman spectrum of the deposited film, the laser source is a 632.8 nm Ne-He laser, the laser power is 35 mW and the resolution is 2 µm.

In the present invention, a multifunctional surface analysis system ESCALAB250 produced by the American Thermo VG is used during XPS analysis, and the X-ray source is a target Al Kα (1486.6eV) ray.

The AFM used in the present invention is Picoscan 2500 produced by Agilent. The morphology of a film sample is tested and analyzed at normal room temperature. The analyzed area of the film sample is {P1}.

### Embodiment 1

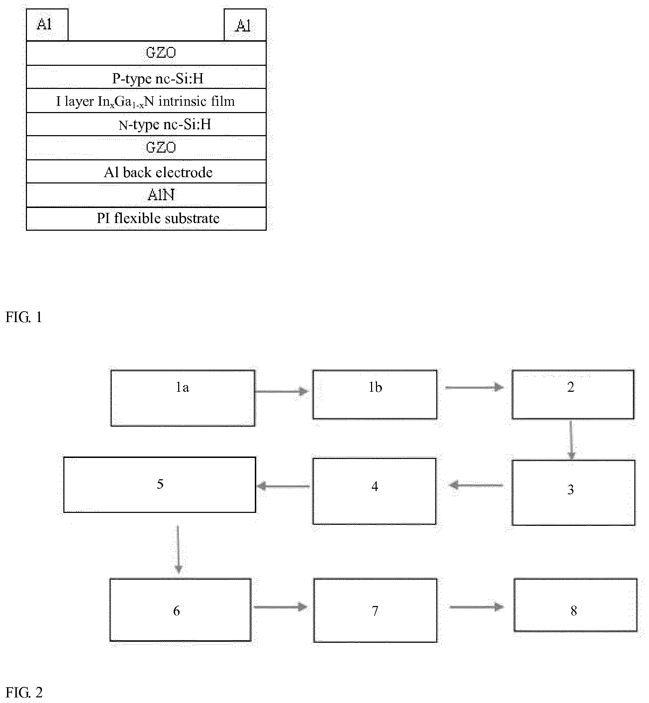

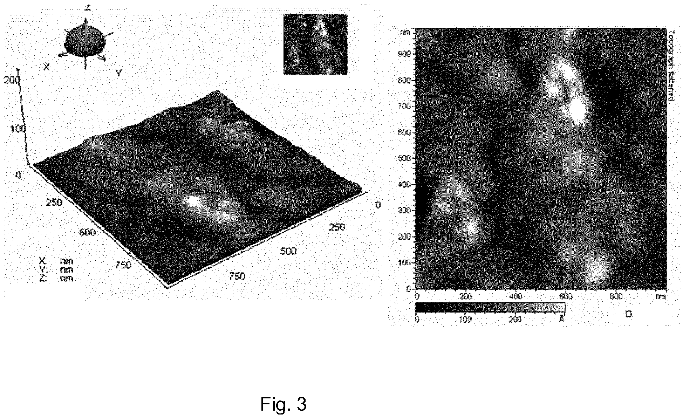

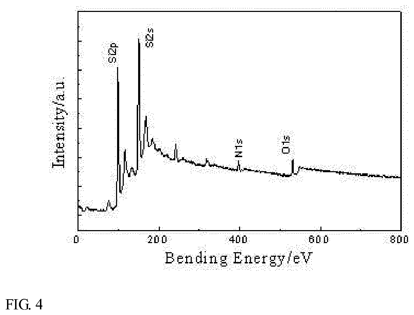

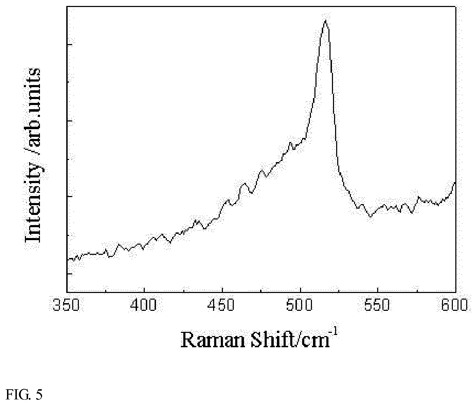

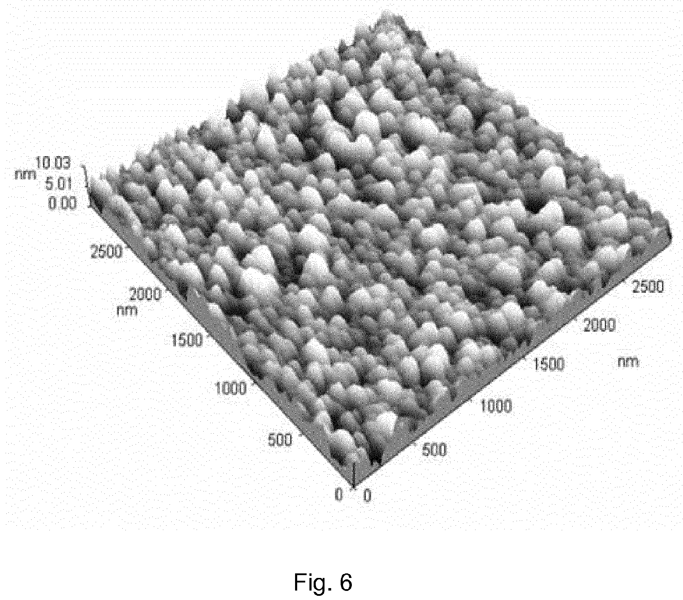

The structure diagram of the solar cell with a flexible substrate of an adjustable bandgap quantum well structure of this embodiment is shown in Figure 1. The preparation method comprises the steps of:
(1) After ultrasonic cleaning (1a) by ionized water for 5 min, drying up the PI substrate by N₂ and putting the PI substrate into a magnetron sputtering reaction chamber to prepare (1b) the AlN insulating layer by deposition at a vacuum of 9.0 × 10⁻⁴ Pa; the process parameters are as follows: the target material is aluminum with a purity of 99.99%, the reaction source is the gas mixture of Ar and N₂, the flow ratio of Ar:N₂ is 6:1, the flexible PI substrate is heated to 100°C, and the deposition time is 30 min.
(2) Preparing the Al metal back electrode by magnetron sputtering; the process parameters are as follows: the reaction source is Ar, the flow rate of Ar is 10 sccm, the temperature of the substrate is 50°C, and the deposition time is 3 min. The structure at this time is Al back electrode/AIN insulating layer/PI flexible substrate.
(3) Preparing one GZO transparent conductive film by the ECR-PEMOCVD system; the process parameters are as follows: the PI flexible substrate with deposited AlN insulating layer and Al back electrode in the reaction chamber is heated to 200°C, Ar carried TMGa, DEZn and O₂ are introduced to the reaction chamber, the flow ratio of TMGa:DEZn:O₂ is 1:2:80, the microwave power is 650 W, the deposition pressure is 0.8 Pa, and the deposition time is 10 min. The structure at this time is GZO/Al back electrode/AIN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 5 sccm, the flow rate of H₂ diluted PH₃ is 0.5 sccm, the flow rate of H₂ is 25 sccm, the deposition temperature is 250 °C, the microwave power is 650 W, the deposition pressure is 0.8 Pa, and the deposition time is 30 min. The structure at this time is N-type nc-Si:H/GZO/Al back electrode/AIN insulating layer/PI flexible substrate.
(5) Preparing the InₓGa₁₋ₓN adjustable bandgap quantum well intrinsic crystal film by the ECR-PEMOCVD system and introducing H₂ diluted TMGa and TMIn to the reaction chamber; the process parameters are as follows: the flow ratio of TMGa:TMIn is 2:1, the flow rate of N₂ is 80 sccm, the deposition temperature is 300°C, the microwave power is 650 W, the deposition pressure is 0.9 Pa, and the deposition time is 40 min. The structure at this time is I layer InₓGa₁₋ₓN intrinsic film/N-type nc-Si:H/GZO/Al back electrode/AIN insulating layer/PI flexible substrate.
   The morphology of the InₓGa₁₋ₓN quantum well intrinsic crystal film is tested and analyzed by an AFM, and the result is shown in Figure 3. As can be seen from Figure 3, the morphology of the InₓGa₁₋ₓN quantum well intrinsic crystal film is flat, and the distribution of crystal grains is uniform.
(6) Preparing the P-type nc-Si:H film by the ECR-PEMOCVD system and introducing Ar diluted SiH₄ and H₂ diluted B₂H₆ to the reaction chamber; the process parameters are as follows: the flow rate of Ar diluted SiH₄ is 5 sccm, the flow rate of H₂ diluted B₂H₆ is 0.3 sccm, the flow rate of H₂ is 25 sccm, the deposition temperature is 250°C, the microwave power is 650 W, the deposition pressure is 0.8 to 1.2 Pa, and the deposition time is 30 min. The structure at this time is P-type nc-Si:H/l layer InₓGa₁₋ₓN intrinsic film/N-type nc-Si:H/GZO/Al back electrode/AIN insulating layer/PI flexible substrate. The obtained P-type nc-Si:H film is tested and analyzed by an XPS analysis equipment, and the result is shown in Figure 4. As can be seen from Figure 4, the P-type nc-Si:H film has good performance. The structural performance of the P-type nc-Si:H film is tested and analyzed by a Raman spectrometer, and the result is shown in Figure 5. As can be seen from Figure 5, the structural performance of the P-type nc-Si:H film is good. The morphology of the P-type nc-Si:H film is tested and analyzed by an AFM, and the result is shown in Figure 6. As can be seen from Figure 6, the morphology of the B-doped P-type nc-Si:H film is flat, and the distribution of crystal grains is uniform.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the deposition temperature is 200°C, the microwave power is 650 W, the deposition pressure is 0.8 Pa, and the deposition time is 10 min. The structure at this time is GZO/P-type nc-Si:H/l layer InₓGa₁₋ₓN intrinsic film/N-type nc-Si:H/GZO/Al back electrode/AIN insulating layer/PI flexible substrate.
(8) Preparing the Al metal electrode by the magnetron sputtering reaction chamber; the process parameters are as follows: the reaction source is Ar, the flow of Ar is 10 sccm, the temperature of the substrate is 50°C, and the deposition time is 3 to 10 min. The structure finally obtained is Al electrode/GZO/P-type nc-Si:H/I layer InₓGa₁₋ₓN intrinsic film/N-type nc-Si:H/GZO/Al back electrode/AlN insulating layer/PI flexible substrate.

### Embodiment 2

The structure diagram of the solar cell with a flexible substrate of an adjustable bandgap quantum well structure of this embodiment is shown in Figure 1. The preparation method comprises the steps of:
(1) After ultrasonic cleaning (1a) by ionized water for 5 min, drying up the PI substrate by N₂ and putting the PI substrate into a magnetron sputtering reaction chamber to prepare (1b) the AlN insulating layer by deposition at a vacuum of 9.0 × 10⁻⁴ Pa; the process parameters are as follows: the target material is aluminum with a purity of 99.99%, the reaction source is the gas mixture of Ar and N₂, the flow ratio of Ar:N₂ is 7:1, the flexible PI substrate is heated to 120°C, and the deposition time is 40 min.
(2) Preparing the Al metal back electrode by magnetron sputtering; the process parameters are as follows: the reaction source is Ar, the flow rate of Ar is 15 sccm, the temperature of the substrate is 100°C, and the deposition time is 6 min. The structure at this time is Al back electrode/AlN insulating layer/PI flexible substrate.
(3) Preparing one GZO transparent conductive film by the ECR-PEMOCVD system; the process parameters are as follows: the PI flexible substrate with deposited AlN insulating layer and Al back electrode in the reaction chamber is heated to 280°C, Ar carried TMGa, DEZn and O₂ are introduced to the reaction chamber, the flow ratio of TMGa:DEZn:O₂ is 1:2:80, the microwave power is 650 W, the deposition pressure is 1.0 Pa, and the deposition time is 15 min. The structure at this time is GZO/Al back electrode/AIN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 6 sccm, the flow rate of H₂ diluted PH₃ is 2 sccm, the flow rate of H₂ is 30 sccm, the deposition temperature is 300 °C, the microwave power is 650 W, the deposition pressure is 1.2 Pa, and the deposition time is 40 min. The structure at this time is N-type nc-Si:H/GZO/Al back electrode/AIN insulating layer/PI flexible substrate.
(5) Preparing the InₓGa₁₋ₓN adjustable bandgap quantum well intrinsic crystal film by the ECR-PEMOCVD system and introducing H₂ diluted TMGa and TMIn to the reaction chamber; the process parameters are as follows: the flow ratio of TMGa:TMIn is 2:1, the flow rate of N₂ is 90 sccm, the deposition temperature is 240°C, the microwave power is 650 W, the deposition pressure is 1.0 Pa, and the deposition time is 50 min. The structure at this time is I layer InₓGa₁₋ₓN intrinsic film/N-type nc-Si:H/GZO/Al back electrode/AIN insulating layer/PI flexible substrate.
(6) Preparing the P-type nc-Si:H film by the ECR-PEMOCVD system and introducing Ar diluted SiH₄ and H₂ diluted B₂H₆ to the reaction chamber; the process parameters are as follows: the flow rate of Ar diluted SiH₄ is 6 sccm, the flow rate of H₂ diluted B₂H₆ is 2 sccm, the flow rate of H₂ is 25 sccm, the deposition temperature is 300 °C, the microwave power is 650 W, the deposition pressure is 1.0 Pa, and the deposition time is 50 min. The structure at this time is P-type nc-Si:H/l layer InₓGa₁₋ₓN intrinsic film/N-type nc-Si:H/GZO/Al back electrode/AlN insulating layer/PI flexible substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the deposition temperature is 250°C, the microwave power is 650 W, the deposition pressure is 1.1 Pa, and the deposition time is 15 min. The structure at this time is GZO/P-type nc-Si:H/l layer InₓGa₁₋ₓN intrinsic film/N-type nc-Si:H/GZO/Al back electrode/AIN insulating layer/PI flexible substrate.
(8) Preparing the Al metal electrode by the magnetron sputtering reaction chamber; the process parameters are as follows: the reaction source is Ar, the flow of Ar is 12 sccm, the temperature of the substrate is 100 °C , and the deposition time is 5 min. The structure finally obtained is Al electrode/GZO/P-type nc-Si:H/l layer InₓGa₁₋ₓN intrinsic film/N-type nc-Si:H/GZO/Al back electrode/AlN insulating layer/PI flexible substrate.

### Embodiment 3

The structure diagram of the solar cell with a flexible substrate of an adjustable bandgap quantum well structure of this embodiment is shown in Figure 1. The preparation method comprises the steps of:
(1) After ultrasonic cleaning (1a) by ionized water for 5 min, drying up the PI substrate by N₂ and putting the PI substrate into a magnetron sputtering reaction chamber to prepare (1b) the AlN insulating layer by deposition at a vacuum of 9.0 × 10⁻⁴ Pa; the process parameters are as follows: the target material is aluminum with a purity of 99.99%, the reaction source is the gas mixture of Ar and N₂, the flow ratio of Ar:N₂ is 9:1, the flexible PI substrate is heated to 200°C, and the deposition time is 60 min.
(2) Preparing the Al metal back electrode by magnetron sputtering; the process parameters are as follows: the reaction source is Ar, the flow rate of Ar is 20 sccm, the temperature of the substrate is 150°C, and the deposition time is 10 min. The structure at this time is Al back electrode/AlN insulating layer/PI flexible substrate.
(3) Preparing one GZO transparent conductive film by the ECR-PEMOCVD system; the process parameters are as follows: the PI flexible substrate with deposited AlN insulating layer and Al back electrode in the reaction chamber is heated to 280°C, Ar carried TMGa, DEZn and O₂ are introduced to the reaction chamber, the flow ratio of TMGa:DEZn:O₂ is 1:2:80, the microwave power is 650 W, the deposition pressure is 1.2 Pa, and the deposition time is 20 min. The structure at this time is GZO/Al back electrode/AlN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 8 sccm, the flow rate of H₂ diluted PH₃ is 5 sccm, the flow rate of H₂ is 40 sccm, the deposition temperature is 350 °C, the microwave power is 650 W, the deposition pressure is 1.0 Pa, and the deposition time is 80 min. The structure at this time is N-type nc-Si:H/GZO/Al back electrode/AIN insulating layer/PI flexible substrate.
(5) Preparing the InₓGa₁₋ₓN adjustable bandgap quantum well intrinsic crystal film by the ECR-PEMOCVD system and introducing H₂ diluted TMGa and TMIn to the reaction chamber; the process parameters are as follows: the flow ratio of TMGa:TMIn is 2:1, the flow rate of N₂ is 120 sccm, the deposition temperature is 200°C, the microwave power is 650 W, the deposition pressure is 1.4 Pa, and the deposition time is 60 min. The structure at this time is I layer InₓGa₁₋ₓN intrinsic film/N-type nc-Si:H/GZO/Al back electrode/AIN insulating layer/PI flexible substrate.
(6) Preparing the P-type nc-Si:H film by the ECR-PEMOCVD system and introducing Ar diluted SiH₄ and H₂ diluted B₂H₆ to the reaction chamber; the process parameters are as follows: the flow rate of Ar diluted SiH₄ is 8 sccm, the flow rate of H₂ diluted B₂H₆ is 8 sccm, the flow rate of H₂ is 25 sccm, the deposition temperature is 350 °C, the microwave power is 650 W, the deposition pressure is 1.2 Pa, and the deposition time is 80 min. The structure at this time is P-type nc-Si:H/I layer InₓGa₁₋ₓN intrinsic film/N-type nc-Si:H/GZO/Al back electrode/AlN insulating layer/PI flexible substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the deposition temperature is 400°C, the microwave power is 650 W, the deposition pressure is 1.2 Pa, and the deposition time is 20 min. The structure at this time is GZO/P-type nc-Si:H/I layer InₓGa₁₋ₓN intrinsic film/N-type nc-Si:H/GZO/Al back electrode/AlN insulating layer/PI flexible substrate.
(8) Preparing the Al metal electrode by the magnetron sputtering reaction chamber; the process parameters are as follows: the reaction source is Ar, the flow of Ar is 20 sccm, the temperature of the substrate is 150°C, and the deposition time is 10 min. The structure finally obtained is Al electrode/GZO/P-type nc-Si:H/I layer InₓGa₁₋ₓN intrinsic film/N-type nc-Si:H/GZO/Al back electrode/AlN insulating layer/PI flexible substrate.

### Embodiment 4

The structure diagram of the solar cell with a flexible substrate of an adjustable bandgap quantum well structure of this embodiment is shown in Figure 1. The preparation method comprises the steps of:
(1) After ultrasonic cleaning (1a) by ionized water for 5 min, drying up the PI substrate by N₂ and putting the PI substrate into a magnetron sputtering reaction chamber to prepare (1b) the AlN insulating layer by deposition at a vacuum of 9.0 × 10⁻⁴ Pa; the process parameters are as follows: the target material is aluminum with a purity of 99.99%, the reaction source is the gas mixture of Ar and N₂, the flow ratio of Ar:N₂ is 4:1, the flexible PI substrate is heated to 180°C, and the deposition time is 50 min.
(2) Preparing the Al metal back electrode by magnetron sputtering; the process parameters are as follows: the reaction source is Ar, the flow rate of Ar is 12 sccm, the temperature of the substrate is 80°C, and the deposition time is 4 min. The structure at this time is Al back electrode/AIN insulating layer/PI flexible substrate.
(3) Preparing one GZO transparent conductive film by the ECR-PEMOCVD system; the process parameters are as follows: the PI flexible substrate with deposited AlN insulating layer and Al back electrode in the reaction chamber is heated to 250°C, Ar carried TMGa, DEZn and O₂ are introduced to the reaction chamber, the flow ratio of TMGa:DEZn:O₂ is 1:2:80, the microwave power is 650 W, the deposition pressure is 0.9 Pa, and the deposition time is 18 min. The structure at this time is GZO/Al back electrode/AIN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 6 sccm, the flow rate of H₂ diluted PH₃ is 1 sccm, the flow rate of H₂ is 25 sccm, the deposition temperature is 320 °C, the microwave power is 650 W, the deposition pressure is 1.0 Pa, and the deposition time is 80 min. The structure at this time is N-type nc-Si:H/GZO/Al back electrode/AIN insulating layer/PI flexible substrate.
(5) Preparing the InₓGa₁₋ₓN adjustable bandgap quantum well intrinsic crystal film by the ECR-PEMOCVD system and introducing H₂ diluted TMGa and TMIn to the reaction chamber; the process parameters are as follows: the flow ratio of TMGa:TMIn is 2:1, the flow rate of N₂ is 115 sccm, the deposition temperature is 240°C, the microwave power is 650 W, the deposition pressure is 1.0 Pa, and the deposition time is 55 min. The structure at this time is I layer InₓGa₁₋ₓN intrinsic film/N-type nc-Si:H/GZO/Al back electrode/AIN insulating layer/PI flexible substrate.
(6) Preparing the P-type nc-Si:H film by the ECR-PEMOCVD system and introducing Ar diluted SiH₄ and H₂ diluted B₂H₆ to the reaction chamber; the process parameters are as follows: the flow rate of Ar diluted SiH₄ is 7 sccm, the flow rate of H₂ diluted B₂H₆ is 4 sccm, the flow rate of H₂ is 25 sccm, the deposition temperature is 260 °C, the microwave power is 650 W, the deposition pressure is 1.2 Pa, and the deposition time is 50 min. The structure at this time is P-type nc-Si:H/I layer InₓGa₁₋ₓN intrinsic film/N-type nc-Si:H/GZO/Al back electrode/AlN insulating layer/PI flexible substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the deposition temperature is 290°C, the microwave power is 650 W, the deposition pressure is 1.1 Pa, and the deposition time is 14 min. The structure at this time is GZO/P-type nc-Si:H/I layer InₓGa₁₋ₓN intrinsic film/N-type nc-Si:H/GZO/Al back electrode/AlN insulating layer/PI flexible substrate.
(8) Preparing the Al metal electrode by the magnetron sputtering reaction chamber; the process parameters are as follows: the reaction source is Ar, the flow of Ar is 20 sccm, the temperature of the substrate is 110°C, and the deposition time is 9 min. The structure finally obtained is Al electrode/GZO/P-type nc-Si:H/I layer InₓGa₁₋ₓN intrinsic film/N-type nc-Si:H/GZO/Al back electrode/AlN insulating layer/PI flexible substrate.

### Embodiment 5

The structure diagram of the solar cell with a flexible substrate of an adjustable bandgap quantum well structure of this embodiment is shown in Figure 1. The preparation method comprises the steps of:
(1) After ultrasonic cleaning (1a) by ionized water for 5 min, drying up the PI substrate by N₂ and putting the PI substrate into a magnetron sputtering reaction chamber to prepare (1b) the AlN insulating layer by deposition at a vacuum of 9.0 × 10⁻⁴ Pa; the process parameters are as follows: the target material is aluminum with a purity of 99.99%, the reaction source is the gas mixture of Ar and N₂, the flow ratio of Ar:N₂ is 10:1, the flexible PI substrate is heated to 120°C, and the deposition time is 30 min.
(2) Preparing the Al metal back electrode by magnetron sputtering; the process parameters are as follows: the reaction source is Ar, the flow rate of Ar is 15 sccm, the temperature of the substrate is 50°C, and the deposition time is 10 min. The structure at this time is Al back electrode/AIN insulating layer/PI flexible substrate.
(3) Preparing one GZO transparent conductive film by the ECR-PEMOCVD system; the process parameters are as follows: the PI flexible substrate with deposited AlN insulating layer and Al back electrode in the reaction chamber is heated to 300°C, Ar carried TMGa, DEZn and O₂ are introduced to the reaction chamber, the flow ratio of TMGa:DEZn:O₂ is 1:2:80, the microwave power is 650 W, the deposition pressure is 1.2 Pa, and the deposition time is 20 min. The structure at this time is GZO/Al back electrode/AIN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 5.5 sccm, the flow rate of H₂ diluted PH₃ is 3 sccm, the flow rate of H₂ is 25 sccm, the deposition temperature is 320 °C, the microwave power is 650 W, the deposition pressure is 0.8 Pa, and the deposition time is 80 min. The structure at this time is N-type nc-Si:H/GZO/Al back electrode/AIN insulating layer/PI flexible substrate.
(5) Preparing the InₓGa₁₋ₓN adjustable bandgap quantum well intrinsic crystal film by the ECR-PEMOCVD system and introducing H₂ diluted TMGa and TMIn to the reaction chamber; the process parameters are as follows: the flow ratio of TMGa:TMIn is 2:1, the flow rate of N₂ is 80 sccm, the deposition temperature is 200°C, the microwave power is 650 W, the deposition pressure is 1.4 Pa, and the deposition time is 45 min. The structure at this time is I layer InₓGa₁₋ₓN intrinsic film/N-type nc-Si:H/GZO/Al back electrode/AIN insulating layer/PI flexible substrate.
(6) Preparing the P-type nc-Si:H film by the ECR-PEMOCVD system and introducing Ar diluted SiH₄ and H₂ diluted B₂H₆ to the reaction chamber; the process parameters are as follows: the flow rate of Ar diluted SiH₄ is 5 sccm, the flow rate of H₂ diluted B₂H₆ is 2 sccm, the flow rate of H₂ is 25 sccm, the deposition temperature is 250 °C, the microwave power is 650 W, the deposition pressure is 0.8 Pa, and the deposition time is 50 min. The structure at this time is P-type nc-Si:H/I layer InₓGaₓ₋₁N intrinsic film/N-type nc-Si:H/GZO/Al back electrode/AIN insulating layer/PI flexible substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the deposition temperature is 250°C, the microwave power is 650 W, the deposition pressure is 1.1 Pa, and the deposition time is 10 min. The structure at this time is GZO/P-type nc-Si:H/I layer InₓGa₁₋ₓN intrinsic film/N-type nc-Si:H/GZO/Al back electrode/AlN insulating layer/PI flexible substrate.
(8) Preparing the Al metal electrode by the magnetron sputtering reaction chamber; the process parameters are as follows: the reaction source is Ar, the flow of Ar is 20 sccm, the temperature of the substrate is 150 °C, and the deposition time is 5 min. The structure finally obtained is Al electrode/GZO/P-type nc-Si:H/l layer InₓGa₁₋ₓN intrinsic film/N-type nc-Si:H/GZO/Al back electrode/AlN insulating layer/PI flexible substrate.

## Claims

1. A solar cell with a flexible substrate and a quantum well structure, wherein polyimide (PI) is used as a flexible substrate, an AlN insulating layer is above the substrate, an Al back electrode is above the AlN insulating layer, a Ga-doped ZnO (GZO) transparent conductive film used as a buffer layer is above the Al back electrode, an N-type hydrogenated nano-crystalline silicon (nc-Si:H) film is above the GZO transparent conductive film, an intrinsic film of InₓGa₁₋ₓN is above the N-type nc-Si:H film, a P-type nc-Si:H film is above the intrinsic film of InₓGa₁₋ₓN, another GZO transparent conductive film is above the P-type nc-Si:H film, and an Al metal electrode is above the GZO transparent conductive film,the specific structure being Al electrode/GZO/P-type nc-Si:H/intrinsic film of InₓGa₁₋ₓN/N-type nc-Si:H/GZO/Al back electrode/AIN insulating layer/PI flexible substrate, wherein the intrinsic film of InₓGa₁₋ₓN has an adjustable bandgap width and a quantum well structure.

2. A preparation method for the solar cell with a flexible substrate and a quantum well structure of Claim 1, comprising the steps of:
(1) After ultrasonic cleaning by ionized water, drying up the PI substrate by N₂ and putting the PI substrate into a magnetron sputtering reaction chamber to prepare the AlN insulating layer by deposition at a vacuum of 9.0 × 10⁻⁴ Pa; the process parameters being as follows: the target material is aluminum, the reaction source is the gas mixture of Ar and N₂, the flow ratio of Ar:N₂ is (4 to 10):1, the flexible PI substrate is heated to 100 to 200°C, and the deposition time is 30 to 60 min.
(2) Preparing the Al metal back electrode by magnetron sputtering; the process parameters being as follows: the reaction source is Ar, the target material is aluminum, the flow rate of Ar is 10 to 20 sccm, the temperature of the substrate is 50 to 150°C, and the deposition time is 3 to 10 min, the structure at this time being Al back electrode/AIN insulating layer/PI flexible substrate.
(3) Preparing one GZO transparent conductive film by an Electron Cyclotron Resonance Plasma Enhanced Chemical Vapor Deposition (ECR-PEMOCVD) system; the process parameters being as follows: the PI flexible substrate with deposited AlN insulating layer and Al back electrode in the reaction chamber is heated to 200 to 400°C, Ar carried trimethyl gallium (TMGa), diethyl zinc (DEZn) and O₂ are introduced to the reaction chamber, the flow ratio of TMGa:DEZn:O₂ is 1:2:80, the microwave power is 650 W, the deposition pressure is 0.8 to 1.2 Pa, and the deposition time is 10 to 20 min, the structure at this time being GZO/Al back electrode/AIN insulating layer/PI flexible substrate.
(4) Preparing the N-type nc-Si:H film by the ECR-PEMOCVD system and introducing Ar diluted SiH₄ and H₂ diluted PH₃ to the reaction chamber; the process parameters being as follows: the flow rate of Ar diluted SiH₄ is 5 to 8 sccm, the flow rate of H₂ diluted PH₃ is 0.5 to 5 sccm, the flow rate of H₂ is 25 to 40 sccm, the deposition temperature is 250 to 350°C, the microwave power is 650 W, the deposition pressure is 0.8 to 1.2 Pa, and the deposition time is 30 to 80 min, the structure at this time being N-type nc-Si:H/GZO/Al back electrode/AIN insulating layer/PI flexible substrate.
(5) Preparing the InₓGa₁₋ₓN quantum well intrinsic crystal film by the ECR-PEMOCVD system and introducing H₂ diluted TMGa and TMIn to the reaction chamber; the process parameters being as follows: the flow ratio of TMGa:TMIn is 2:1, the flow rate of N₂ is 80 to 120 sccm, the deposition temperature is 200 to 300°C, the microwave power is 650 W, the deposition pressure is 0.9 to 1.4 Pa, and the deposition time is 40 to 60 min, the structure at this time being intrinsic film of InₓGa₁₋ₓN/N-type nc-Si:H/GZO/Al back electrode/AIN insulating layer/PI flexible substrate.
(6) Preparing the P-type nc-Si:H film by the ECR-PEMOCVD system and introducing Ar diluted SiH₄ and H₂ diluted B₂H₆ to the reaction chamber; the process parameters being as follows: the flow rate of Ar diluted SiH4 is 5 to 8 sccm, the flow rate of H₂ diluted B₂H₆ is 0.3 to 8 sccm, the flow rate of H₂ is 25 sccm, the deposition temperature is 250 to 350°C, the microwave power is 650 W, the deposition pressure is 0.8 to 1.2 Pa, and the deposition time is 30 to 80 min, the structure at this time being P-type nc-Si:H/ intrinsic film of InₓGa₁₋ₓN /N-type nc-Si:H/GZO/Al back electrode/AIN insulating layer/PI flexible substrate.
(7) Preparing the other GZO transparent conductive film by the ECR-PEMOCVD system and introducing Ar carried TMGa, DEZn and O₂ to the reaction chamber; the process parameters being as follows: the flow ratio of TMGa:DEZn:O₂ is 1:2:80, the deposition temperature is 200 to 400°C, the microwave power is 650 W, the deposition pressure is 0.8 to 1.2 Pa, and the deposition time is 10 to 20 min, the structure at this time being GZO/P-type nc-Si:H/ intrinsic film of InxGa1-xN/N-type nc-Si:H/GZO/Al back electrode/AIN insulating layer/PI flexible substrate.
(8) Preparing the Al metal electrode by the magnetron sputtering reaction chamber; the process parameters being as follows: the reaction source is Ar, the target material is aluminum, the flow of Ar is 10 to 20 sccm, the temperature of the substrate is 50 to 150°C, and the deposition time is 3 to 10 min, the structure finally obtained being Al electrode/GZO/P-type nc-Si:H/ intrinsic film of InₓGa₁₋ₓN /N-type nc-Si:H/GZO/Al back electrode/AIN insulating layer/PI flexible substrate.

3. The preparation method for the solar cell with a flexible substrate and a quantum well structure of Claim 2, wherein the target material of aluminum used during magnetron sputtering has a purity of 99.99%.

## Patentansprüche

1. Solarzelle mit flexiblem Substrat und einer Quantentopfstruktur, wobei Polyimid (PI) als flexibles Substrat verwendet wird, eine AlN-Isolierschicht über dem Substrat ist, eine Al-Rückelektrode über der AlN-Isolierschicht ist, ein transparenter leitfähiger Film aus Ga-dotiertem ZnO (GZO), der als Pufferschicht verwendet wird, über der Al-Rückelektrode ist, ein Film aus hydriertem nanokristallinem Silicium (nc-Si:H) vom N-Typ über dem transparenten leitfähigen GZO-Film ist, ein intrinsischer Film aus InₓGa₁₋ₓN über dem N-Typ-nc-Si: H-Film ist, ein P-Typ-nc-Si:H-Film über dem intrinsischen Film aus InₓGa₁₋ₓN ist, ein weiterer transparenter leitfähiger GZO-Film über dem P-Typ-nc-Si:H-Film ist und eine Al-Metallelektrode über dem transparenten leitfähigen GZO-Film ist, wobei die spezifische Struktur Al-Elektrode/GZO/P-Typ-nc-Si:H/intrinsischer Film aus InₓGa₁₋ₓN/N-Typ-nc-Si:H/GZO/Al-Rückelektrode/AlN-Isolierschicht/flexibles PI-Substrat ist, wobei der intrinsische Film aus InₓGa₁₋ₓN eine einstellbare Bandlückenbreite und eine Quantentopfstruktur aufweist.

2. Verfahren zum Herstellen der Solarzelle mit einem flexiblen Substrat und einer Quantentopfstruktur nach Anspruch 1, das die Schritte umfasst:
(1) Nach Ultraschallreinigen mit ionisiertem Wasser Austrocknen des PI-Substrats mit N₂ und Platzieren des PI-Substrats in einer Magnetronsputterreaktionskammer zur Herstellung der AlN-Isolierschicht durch Abscheiden unter einem Vakuum von 9,0 × 10⁻⁴ Pa; wobei die Prozessparameter wie folgt sind: Das Zielmaterial ist Aluminium, die Reaktionsquelle ist die Gasmischung von Ar und N₂, das Durchflussverhältnis von Ar:N₂ beträgt (4 bis 10) :1, das flexible PI-Substrat wird auf 100 bis 200 °C erhitzt und die Abscheidungszeit beträgt 30 bis 60 min.
(2) Herstellen der Al-Metallrückelektrode durch Magnetronsputtern; wobei die Prozessparameter wie folgt sind: Die Reaktionsquelle ist Ar, das Zielmaterial ist Aluminium, die Durchflussrate von Ar beträgt 10 bis 20 sccm, die Temperatur des Substrats beträgt 50 bis 150 °C und die Abscheidungszeit beträgt 3 bis 10 min, wobei die Struktur dieses Mal Al-Rückelektrode/AlN-Isolierschicht/flexibles PI-Substrat ist.
(3) Herstellen eines transparenten leitfähigen GZO-Films durch ein Elektronen-Zyklotron-Resonanz-Plasmaunterstützte-Chemische-Gasphasenabscheidung-(ECR-PEMOCVD)-System; wobei die Prozessparameter wie folgt sind: Das flexible PI-Substrat mit abgeschiedener AlN-Isolierschicht und Al-Rückelektrode in der Reaktionskammer wird auf 200 bis 400 °C erhitzt, Ar-getragenes Trimethylgallium (TMGa), Diethylzink (DEZn) und O₂ werden in die Reaktionskammer eingebracht, das Durchflussverhältnis von TMGa:DEZn:O₂ beträgt 1:2:80, die Mikrowellenleistung beträgt 650 W, der Abscheidungsdruck beträgt 0,8 bis 1,2 Pa und die Abscheidungszeit beträgt 10 bis 20 min, wobei die Struktur dieses Mal GZO/Al-Rückelektrode/AlN-Isolierschicht/flexibles PI-Substrat ist.
(4) Herstellen des N-Typ-nc-Si:H-Films durch das ECR-PEMOCVD-System und Einbringen von Ar-verdünntem SiH₄ und H₂-verdünntem PH₃ in die Reaktionskammer; wobei die Prozessparameter wie folgt sind: Die Durchflussrate von Ar-verdünntem SiH₄ beträgt 5 bis 8 sccm, die Durchflussrate von H₂-verdünntem PH₃ beträgt 0,5 bis 5 sccm, die Durchflussrate von H₂ beträgt 25 bis 40 sccm, die Abscheidungstemperatur beträgt 250 bis 350 °C, die Mikrowellenleistung beträgt 650 W, der Abscheidungsdruck beträgt 0,8 bis 1,2 Pa und die Abscheidungszeit beträgt 30 bis 80 min, wobei die Struktur dieses Mal N-Typ-nc-Si:H/GZO/Al-Rückelektrode/AlN-Isolierschicht/flexibles PI-Substrat ist.
(5) Herstellen des intrinsischen InₓGa₁₋ₓN-Quantentopf-Kristallfilms durch das ECR-PEMOCVD-System und Einbringen von H₂-verdünntem TMGa und TMIn in die Reaktionskammer; wobei die Prozessparameter wie folgt sind: Das Durchflussverhältnis von TMGa:TMIn beträgt 2:1, die Durchflussrate von N₂ beträgt 80 bis 120 sccm, die Abscheidungstemperatur beträgt 200 bis 300°C, die Mikrowellenleistung beträgt 650 W, der Abscheidungsdruck beträgt 0,9 bis 1,4 Pa und die Abscheidungszeit beträgt 40 bis 60 min, wobei die Struktur dieses Mal intrinsischer Film aus InₓGa₁₋ₓN/N-Typ-nc-Si:H/GZO/Al-Rückelektrode/AlN-Isolierschicht/flexibles PI-Substrat ist.
(6) Herstellen des P-Typ-nc-Si:H-Films durch das ECR-PEMOCVD-System und Einbringen von Ar-verdünntem SiH₄ und H₂-verdünntem B₂H₆ in die Reaktionskammer; wobei die Prozessparameter wie folgt sind: Die Durchflussrate von Ar-verdünntem SiH₄ beträgt 5 bis 8 sccm, die Durchflussrate von H₂-verdünntem B₂H₆ beträgt 0,3 bis 8 sccm, die Durchflussrate von H₂ beträgt 25 sccm, die Abscheidungstemperatur beträgt 250 bis 350 °C, die Mikrowellenleistung beträgt 650 W, der Abscheidungsdruck beträgt 0,8 bis 1,2 Pa und die Abscheidungszeit beträgt 30 bis 80 min, wobei die Struktur dieses Mal P-Typ-nc-Si:H/intrinsischer Film aus InₓGa₁₋ₓN/N-Typ-nc-Si:H/GZO/Al-Rückelektrode/AlN-Isolierschicht/flexibles PI-Substrat ist.
(7) Herstellen des anderen transparenten leitfähigen GZO-Films durch das ECR-PEMOCVD-System und Einbringen von Argetragenem TMGa, DEZn und O₂ in die Reaktionskammer; wobei die Prozessparameter wie folgt sind: Das Durchflussverhältnis von TMGa:DEZn:O₂ beträgt 1:2:80, die Abscheidungstemperatur beträgt 200 bis 400 °C, die Mikrowellenleistung beträgt 650 W, der Abscheidungsdruck beträgt 0,8 bis 1,2 Pa und die Abscheidungszeit beträgt 10 bis 20 min, wobei die Struktur dieses Mal GZO/P-Typ-nc-Si:H/intrinsischer Film aus InxGa1-xN/N-Typ-nc-Si:H/GZO/Al-Rückelektrode/AlN-Isolierschicht/flexibles PI-Substrat ist.
(8) Herstellen der Al-Metallelektrode durch die Magnetronsputterreaktionskammer; wobei die Prozessparameter wie folgt sind: Die Reaktionsquelle ist Ar, das Zielmaterial ist Aluminium, der Durchfluss von Ar beträgt 10 bis 20 sccm, die Temperatur des Substrats beträgt 50 bis 150 °C und die Abscheidungszeit beträgt 3 bis 10 min, wobei die schließlich erhaltene Struktur Al-Elektrode/GZO/P-Typ-nc-Si:H/intrinsischer Film aus InₓGa₁₋ₓN/N-Typ-nc-Si:H/GZO/Al-Rückelektrode/AlN-Isolierschicht/flexibles PI-Substrat ist.

3. Verfahren zum Herstellen der Solarzelle mit einem flexiblen Substrat und einer Quantentopfstruktur nach Anspruch 2, wobei das Zielmaterial von Aluminium, das während des Magnetronsputterns verwendet wird, eine Reinheit von 99,99 % aufweist.

## Revendications

1. Cellule photovoltaïque à substrat flexible et structure à puits quantique, dans laquelle :
on utilise du polyimide (PI) comme substrat flexible, une couche isolante AIN est située au-dessus du substrat, une électrode arrière en Al est située au-dessus de la couche isolante AIN, un film conducteur transparent en ZnO dopé au Ga (GZO), utilisé comme couche tampon, est situé au-dessus de l'électrode arrière Al, un film de silicium hydrogéné nanocristallin de type N (nc-Si:H) est situé au-dessus de la couche du film conducteur transparent GZO, un film intrinsèque de InₓGa₁₋ₓN est situé au-dessus du film nc-Si:H de type N, un film nc-Si:H de type P est situé au-dessus du film intrinsèque de InₓGa₁₋ₓN, un autre film conducteur transparent GZO est situé au-dessus du film nc-Si:H de type P, et une électrode en Al métallique est située au-dessus du film conducteur transparent GZO, la structure spécifique étant électrode Al / GZO / nc-Si:H de type P / film intrinsèque de InₓGa₁₋ₓN / nc-Si:H de type N / GZO / électrode arrière Al / couche isolante AIN / substrat flexible PI, où le film intrinsèque de InₓGa₁₋ₓN a une bande interdite ajustable et une structure à puits quantique.

2. Procédé de préparation de la cellule photovoltaïque à substrat flexible et structure à puits quantique selon la revendication 1, comprenant les étapes de :
(1) Après nettoyage aux ultrasons par eau désionisée, séchage du substrat PI par N₂ et placement du substrat PI dans une chambre réactionnelle à pulvérisation magnétron pour préparer la couche isolante AIN par dépôt sous un vide de 9,0.10⁻⁴ Pa ; les paramètres de procédé étant comme suit : le matériau cible est l'aluminium, la source réactionnelle est le mélange gazeux d'Ar et N₂, le rapport d'écoulement Ar:N₂ est de 4:1 à 10:1, le substrat PI flexible est chauffé à de 100 à 200°C, et la durée de dépôt est de 30 à 60 min.
(2) Préparation de l'électrode arrière d'Al métal par pulvérisation magnétron ; les paramètres de procédé étant comme suit : le matériau cible est l'aluminium, le débit d'Ar est de 10 à 20 sccm, la température du substrat est de 50 à 150°C, et la durée de dépôt est de 3 à 10 min, la structure à ce moment étant électrode arrière d'Al / couche isolante AIN / substrat flexible PI.
(3) Préparation d'un film conducteur transparent GZO par système de dépôt chimique en phase vapeur assistée par plasma à résonance cyclotron électronique (ECR-PEMOCVD) ; les paramètres de procédé étant comme suit : le substrat flexible PI avec couche isolante AIN déposée et électrode arrière Al dans la chambre réactionnelle est chauffé à de 200 à 400°C, du triméthylgallium (TMGa) sous Ar, du diéthylzinc (DEZn) et O₂ sont introduits dans la chambre de réaction, le rapport d'écoulement TMGa:DEZn:O₂ est 1:2:80, la puissance des micro-ondes est 650 W, la pression de dépôt est de 0,8 à 1,2 Pa, et la durée de dépôt est de 10 à 20 min, la structure à ce moment étant GZO / électrode arrière d'Al / couche isolante AIN / substrat flexible PI.
(4) Préparation du film nc-Si:H de type N par système de dépôt chimique en phase vapeur assistée par plasma à résonance cyclotron électronique (ECR-PEMOCVD) et introduction de SiH₄ dilué dans Ar et PH₃ dilué dans H₂ dans la chambre de réaction ; les paramètres de procédé étant comme suit : le débit d'écoulement de SiH₄ dilué dans Ar est 5 à 8 sccm, le débit d'écoulement de PH₃ dilué dans H₂ est 0,5 à 5 sccm, le débit de H₂ est 25 à 40 sccm, la température de dépôt est de 250 à 350°C, la puissance des micro-ondes est 650 W, la pression de dépôt est de 0,8 à 1,2 Pa, et la durée de dépôt est de 30 à 80 min, la structure à ce moment étant nc-Si:H type N / GZO / électrode arrière d'Al / couche isolante AIN / substrat flexible PI.
(5) Préparation du film cristallin intrinsèque à puits quantique InₓGa₁₋ₓN par système de dépôt chimique en phase vapeur assistée par plasma à résonance cyclotron électronique (ECR-PEMOCVD) et introduction de TMGa dilué dans H₂ et TMIn dans la chambre de réaction ; les paramètres de procédé étant comme suit : le rapport d'écoulement TMGa:TMIn est de 2:1, le débit d'écoulement de N₂ est de 80 à 120 sccm, la température de dépôt est de 200 à 300°C, la puissance des micro-ondes est 650 W, la pression de dépôt est de 0,9 à 1,4 Pa, et la durée de dépôt est de 40 à 60 min, la structure à ce moment étant InₓGa₁₋ₓN / nc-Si : H type N / GZO / électrode arrière d'Al / couche isolante AIN / substrat flexible PI.
(6) Préparation du film nc-Si:H de type P par système de dépôt chimique en phase vapeur assistée par plasma à résonance cyclotron électronique (ECR-PEMOCVD) et introduction de SiH₄ dilué dans H₂ et B₂H₆ dilué dans H₂ dans la chambre de réaction ; les paramètres de procédé étant comme suit : le débit d'écoulement de SiH₄ dilué dans Ar est 5 à 8 sccm, le débit d'écoulement de B₂H₆ dilué dans H₂ est 0,3 à 8 sccm, le débit de H₂ est 25 sccm, la température de dépôt est de 250 à 350°C, la puissance des micro-ondes est 650 W, la pression de dépôt est de 0,8 à 1,2 Pa, et la durée de dépôt est de 30 à 80 min, la structure à ce moment étant Si: H type P / InₓGa₁₋ₓN / nc-Si:H type N / GZO / électrode arrière d'Al / couche isolante AIN / substrat flexible PI.
(7) Préparation de l'autre film conducteur transparent GZO par système de dépôt chimique en phase vapeur assistée par plasma à résonance cyclotron électronique (ECR-PEMOCVD) et introduction de TMGa sous Ar, DEZn et O₂ dans la chambre de réaction ; les paramètres de procédé étant comme suit : le rapport d'écoulement TMGa:DEZn:O₂ est 1:2:80, la température de dépôt est de 200 à 400°C, la puissance des micro-ondes est 650 W, la pression de dépôt est de 0,8 à 1,2 Pa, et la durée de dépôt est de 10 à 20 min, la structure à ce moment étant GZO / Si: H type P / InₓGa₁₋ₓN / nc-Si:H type N / GZO / électrode arrière d'Al / couche isolante AIN / substrat flexible PI.
(8) Préparation de l'électrode Al métal par la chambre de réaction à pulvérisation magnétron ; les paramètres de procédé étant comme suit : le matériau cible est l'aluminium, le débit d'Ar et 10 à 20 sccm, la température du substrat est 50 à 150°C, et la durée de dépôt est de 3 à 10 min, la structure finalement obtenue étant électrode Al / GZO / Si: H type P / InₓGa₁₋ₓN / nc-Si : H type N / GZO / électrode arrière d'Al / couche isolante AIN / substrat flexible PI.

3. Procédé de préparation de la cellule photovoltaïque à substrat flexible et structure à puits quantique selon la revendication 2, dans lequel le matériau cible de l'aluminium utilisé pendant la pulvérisation magnétron a une pureté de 99,99 %.
